Europäisches Patentamt

European Patent Office

Office européen des brevets

(11) Publication number: 0 379 155
A2

(12) **EUROPEAN PATENT APPLICATION**

(21) Application number: 90100851.6

(22) Date of filing: 16.01.90

(51) Int. Cl.⁵: G01R 31/318

(30) Priority: 17.01.89 JP 9256/89

(43) Date of publication of application:
25.07.90 Bulletin 90/30

(84) Designated Contracting States:
DE IT

(71) Applicant: SHARP KABUSHIKI KAISHA
22-22 Nagaike-cho Abeno-ku
Osaka-shi Osaka-fu(JP)

(72) Inventor: Horie, Nobuyuki
2613-1, Ichinomoto-cho
Tenri-shi, Nara-ken(JP)
Inventor: Yamanaka, Toshihiro
4310, Kamimachi
Ikoma-shi, Nara-ken(JP)
Inventor: Nishioka, Yoshiki
160-19, Shoji-cho
Tenri-shi, Nara-ken(JP)
Inventor: Taguchi, Aisaku
2613-1, Ichinomoto-cho
Tenri-shi, Nara-ken(JP)

(74) Representative: TER MEER - MÜLLER -
STEINMEISTER & PARTNER
Mauerkircherstrasse 45
D-8000 München 80(DE)

(54) **Large scale integration circuit device.**

(57) A large scale integration circuit device com-
prises a plurality of registers (1a, 1b, 1c) serving as
the output port of a CPU. Each of the register (1a,
1b, 1c) is composed of a plurality of latches having a
write control signal terminal ( $\overline{G}$ ) and a plurality of
OR gates (3a, 3b, 3c) connected to the corresponding registers (1a, 1b, 1c). Each OR gate (3a, 3b, 3c)
has its one input terminal connected to receive a
write control signal addressed to a relevant register
and another input terminal connected in common to
receive a write control signal address common to all
of the registers (1a, 1b, 1c). A further terminal con-
nected to the write control signal terminal ( $\overline{G}$ ) of the
relevant register (1a, 1b, 1c) is provided on the
integration circuit device.

*Fig. 4*

## LARGE SCALE INTEGRATION CIRCUIT DEVICE

BACKGROUND OF THE INVENTION

<Field of the Invention>

The present invention relates to a large scale integration circuit, hereinafter referred to as LSI, having a plurality of registers as the data output port of the CPU, each of which is composed of a plurality of latches as essential memory elements.

<Description of the Prior Arts>

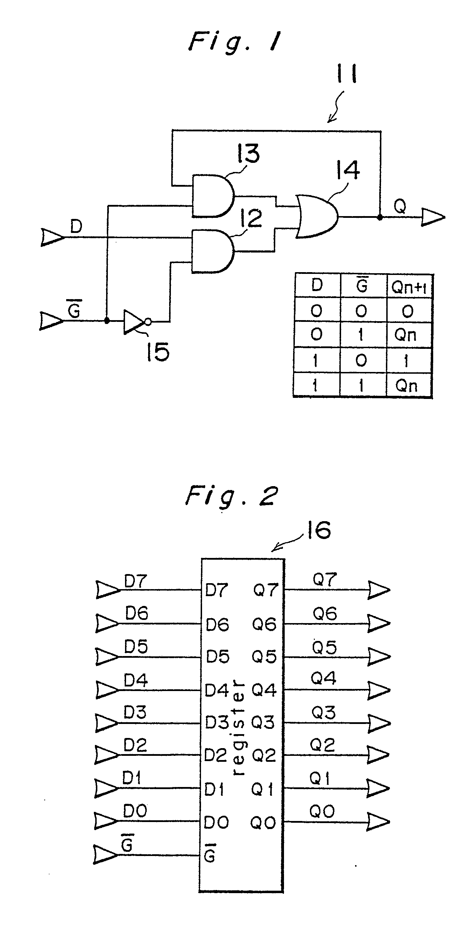

Fig. 1 shows a latch composing a register used in a LSI of this kind. Referring to Fig. 1, a reference numeral 11 is a latch composed of two AND gates 12 and 13, and an OR gate 14 for receiving the outputs from both of them. The AND gate 12 receives a data signal D, and also a write control signal $\overline{G}$ inverted in a NOT gate 15, while the other AND gate 13 receives the write control signal $\overline{G}$, and an output signal Q fed back by the OR gate 14. The truth table in Fig. 1 shows the relationship between the input and output of the latch. As apparent from the truth table, if the write control signal $\overline{G}$ indicates "1", the previous output signal Qn is maintained and outputted irrelevant to the value "0" or "1" of the data signal D of the input operand, while if it indicates "0", the data signal of the input operand is directly outputted.

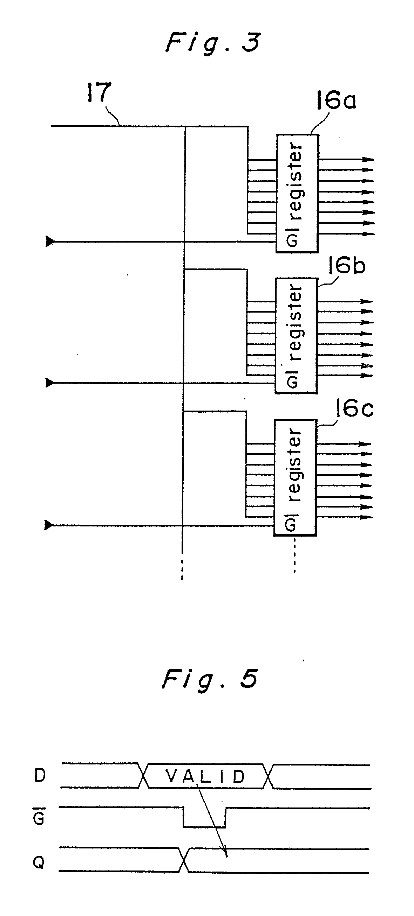

Fig. 2 shows the register 16 in which eight latches 11 are built-in in parallel to one another with a write control signal line of each register connected as the common terminal $\overline{G}$. As shown in the timing chart of Fig. 3, the register 16 has no reset signal terminal, and fetches the 8-bit data signal D (D0 to D7) of the input side in synchronization with the fall of the write control signal $\overline{G}$ inputted to the write control terminal $\overline{G}$, and continues to output it as a 8-bit output signal Q (Q0 to Q7) till the next fall of write control signal $\overline{G}$. Since the register 16 is composed of the latches 11 without any reset signal terminals, it produces a merit that its chip surface area can be decreased to one fourth to one third of that of the conventional register composed mainly of flip-flops having reset signal terminals.

Conventional LSI output units using the registers having the advantage mentioned above are connected as shown in Fig. 3 and the LSI output units are used as the output units of CPUs. The CPU (not shown) feeds data to each of registers 16a, 16b, 16c, ... through a 8-bit data bus 17. Each register receives a write control signal $\overline{G}$ at its

terminal $\overline{G}$ from the CPU, and stores the data, and outputs the stored data, from the output port of the LSI.

Generally, in a register without a reset signal terminal, the output Q is unstable at the time just after the power source is supplied due to the condition defined by the truth table shown in Fig. 1. For this reason, in order to obtain stable output Q in the conventional LSI it is necessary that the CPU sequentially outputs to the respective terminals $\overline{G}$ ers 16a, 16b, 16c, ... the write control signals $\overline{G}$ indicating the respective registers 16a, 16b, 16c..., when the power source is supplied and the registers 16a, 16b, 16c... store the data in the data bus 17. The output Q of the respective registers must be swiftly stabilized so as to save the time and steps of the device test of numerous LSIs before they are flowed from the factory. The conventional LSIs however have such a problem that the CPU must output sequentially write signals $\overline{G}$ to the respective terminals $\overline{G}$ of the respective registers in order to write the data to the respective register 16a, 16b, 16c... consecutively, therefore, in order to determine the output of all the registers, several tens patterns of cycles are required. In the meantime, if a register equipped with a reset signal terminal is employed to swiftly establish a stable output, several logical gates must be increased, whereby the chip surface area of LSI is increased three- or four-folds, resulting in not only preventing the decrement of LSI size but also increasing the manufacturing cost.

An object of the present invention is to provide LSI output units which is possible to decrease the chip size and the manufacturing cost using a register without any reset signal terminal, and also may determine the output of all of the registers more swiftly by the use of several patterns of cyclic operations.

SUMMARY OF THE INVENTION

To achieve the above mentioned object, the large scale integration circuit device according to the present invention comprises a large scale integration circuit device comprising a plurality of registers serving as the output port of a central processing unit or CPU, each of the register being composed of a plurality of latches as essential memory elements, having a write control signal terminal a plurality of OR gates, connected to the corresponding registers, each having one input terminal connected to receive a write control signal addressed to a relevant register and another input terminal connected in common to receive a write control signal addressed common to all of the registers, with terminal connected to the write control signal terminal of the relevant register.

<Operation>

Write control signals common to all of the registers are inputted to the respective input terminals at one sides of the OR gates connected to the respective registers. The OR gate then outputs the write control signal to the write control signal terminal of the register, ignoring the presence or absence of a write control signal inputted to the other input terminal thereof. Then, the data inputted from the CPU is simultaneously written to all the registers, thereby completing the writing operation for all the registers at one time, namely, the initial value setting of the output port when charged by the power source. If the write control signals common to all the registers are not inputted to the other input terminals of the respective OR gates connected to the respective registers, the OR gates directly output, to the write control signal terminals of the registers, the write control signals which will be inputted to the other input terminals of the OR gates. Accordingly, the data inputted from the CPU is written to the respective registers in synchronization with the write control signal inputted thereto.

BRIEF DESCRIPTION OF THE DRAWINGS

Fig. 1 is a circuit diagram of a latch used in a register of LSI;
Fig. 2 is a diagram for showing a register;
Fig. 3 is a circuit diagram for illustrating the output port of the conventional LSI;
Fig. 4 is a circuit diagram for illustrating an example of an output port of the LSI according to the present invention; and
Fig. 5 is a timing chart for illustrating the operation of the register.

DETAILED DESCRIPTION OF THE PREFERRED EMBODIMENTS

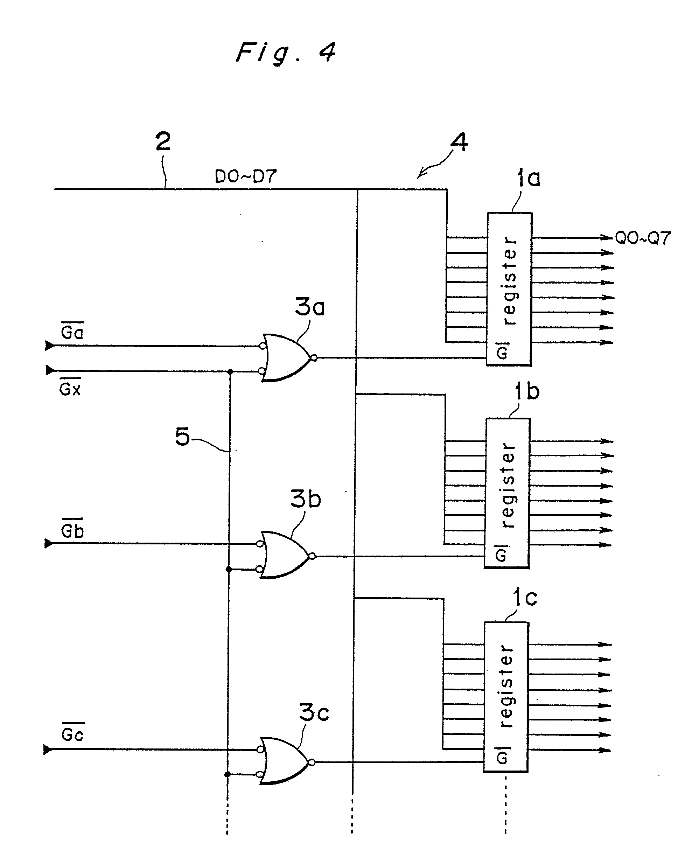

Fig. 4 is a circuit diagram for illustrating an example of the output port portion of LSI according to the present invention, in which 1a, 1b, 1c, ... are registers, each of which is composed of 8 latches connected to act as 8 bit memory elements, and is provided with a write control signal terminal $\overline{G}$ without any reset signal terminal. Each of the registers 1a, 1b, 1c... stores the data outputted from CPU (not shown) through a 8-bit data bus 2, 3a, 3b, 3c, ... are OR gates respectively connected to the write control signal terminals $\overline{G}$ of the registers 1a, 1b, 1c, ..., one input terminals of the OR gates are adapted to receive the write control signals Ga, Gb, Gc, addressed to a, b, c, with the other input terminals commonly connected to receive a common write control signal Gx addressed to x, thereby outputting the logical sum of both write control signals.

Each of registers 1a, 1b, 1c, ... is composed of latches in the same manner and configuration as those of the conventional register 11 shown in Fig. 1 and Fig. 2. Each register fetches the data D of 8-bit (any of data D0 to D7) in synchronization with the fall of the write control signal G inputted to the write control signal terminal $\overline{G}$ in the same manner as shown in Fig. 5, and continue to output this data D as output data Q of 8-bit (any of data Q0 to Q7) until the next write control signal G falls. When each of the OR gates 3a, 3b, 3c, ... receives a falling write control signal $\overline{Gx}$ at the other input terminals thereof, all of the OR gates 3a, 3b, 3c output the falling write control signal $\overline{G}$, independent of the presence or absence of the falling write control signal $\overline{Ga}$, $\overline{Gb}$, or $\overline{Gc}$. On the contrary, when the common write control signal Gx is not inputted to the OR gates, the write control signals $\overline{Ga}$, $\overline{Gb}$, or $\overline{Gc}$ are applied to the relevant register through the relevant OR gates.

The LSI arranged in the manner as above described, operates as follows.

The CPU outputs a write control signal $\overline{Gx}$, which is common to all registers, to the other input terminals of each of OR gates 3a, 3b, 3c, ... through the common signal line 5. Then, each OR gate outputs the falling write control signal to the write control signal terminal $\overline{G}$ of the relevant register, independent of the presence or absence of the write control signal inputted to one input terminals of the OR gates. Thus, the data D indicating, for example, "0" of 8-bit inputted from the CPU is written to all of the registers 1a, 1b, 1c, ... at one time, so that the writing operation for all of the registers, namely, the initial value setting of data for the output port is completed at one time when the power source is supplied to the LSI 4. In the case where the common write control signal $\overline{Gx}$ is not inputted to the OR gates 3a, 3b, 3c, ..., the OR gates 3a, 3b, 3c directly output the write control signal Ga, Gb, Gc, ..., respectively. For example, when the write control signal Ga is received at the input terminal of the OR gate 3a, from the CPU, the write control signal is applied to the $\overline{G}$ terminal of the register 1a. Accordingly, in synchronization with the write control signal inputted to each register, the next data D of 8-bit inputted from the CPU can be written in the relevant register.

As mentioned above, in this embodiment, the OR gates 3a, 3b, 3c, ... are connected to the registers 1a, 1b, 1c, ... without no but reset signal terminals can be omitted, therefore the LSI can be downsized and manufactured at lower cost. In addition the write control signal $\overline{Gx}$ common to all registers, and outputs the logical sum to the write control signal terminal $\overline{G}$ of the relevant register. Accordingly, with this embodiment, the initial value can be set in all registers at one time in response to application of the common write control signal $\overline{Gx}$, so that the output data of the LSI of the present invention can be established with the use of several patterns with a rapid speed, in comparison with the conventional LSI. Therefore, the test pattern time can be reduced, which leads to the improvement of the developablity of LSIs, and furthermore, the chips of LSIs can be downsized and manufactured at a lower cost.

In addition, in this embodiment, a plurality of registers serving as the output port of the CPU can be used for the input of operation data of the LSI. It is needless to say that the present invention is not limited to this embodiment shown in the accompanying drawings, and the variations and modifications thereof are of course possible in light of the above teachings.

## Claims

1. A large scale integration circuit device, **characterized by** a plurality of registers (1a, 1b, 1c) serving as the output port of a central processing unit or CPU, each of the register (1a, 1b, 1c) being composed of a plurality of latches as essential memory elements, having a write control signal terminal ($\overline{G}$), a plurality of OR gates (3a, 3b, 3c), connected to the corresponding registers (1a, 1b, 1c), each having one input terminal connected to receive a write control signal addressed to a relevant register and another input terminal connected in common to receive a write control signal addressed common to all of the registers (1a, 1b, 1c) with terminal connected to the write control signal terminal ($\overline{G}$) of the relevant registers (1a, 1b, 1c).

## Fig. 1

| D | $\bar{G}$ | Qn+1 |
|---|---|---|
| O | O | O |
| O | 1 | Qn |
| 1 | O | 1 |
| 1 | 1 | Qn |

## Fig. 2

# Fig. 3

17          16a

GI register

16b

GI register

16c

GI register

# Fig. 5

D        VALID

$\overline{G}$

Q

# Fig. 4